# EUROPEAN PATENT APPLICATION

(11) **EP 4 236 641 A1**
(43) Date of publication of application: **30.08.2023**
(21) Application number: 21890637.8
(22) Date of filing: 29.06.2021
(51) Int. Cl.: H05K 7/20

(54) **PLUGGABLE DEVICE, INFORMATION COMMUNICATION DEVICE, HEAT DISSIPATION SYSTEM, AND MANUFACTURING METHOD**

(30) Priority: 13.11.2020 CN 202011266492; 26.02.2021 CN 202110221094
(71) Applicant: Huawei Technologies Co., Ltd., Shenzhen, Guangdong 518129 (CN)
(72) Inventor: LI, Cheng, Shenzhen, Guangdong 518129 (CN); WANG, Lianqiang, Shenzhen, Guangdong 518129 (CN); YANG, Yong, Shenzhen, Guangdong 518129 (CN); HE, Yongtao, Shenzhen, Guangdong 518129 (CN); ZHANG, Zhengtao, Shenzhen, Guangdong 518129 (CN)
(74) Representative: Körber, Martin Hans
(86) International application number: PCT/CN2021/103259
(87) International publication number: WO 2022/100106

(57) **Abstract**

This application discloses a pluggable device, an information communication device, a heat dissipation system, and a manufacturing method, and belongs to the field of heat dissipation technologies. The pluggable device includes a housing, a circuit board, a heat emitting element, and a liquid cooling part. The circuit board, the heat emitting element, and the liquid cooling part are sequentially stacked in the housing, and two pipe joints of the liquid cooling part are both fastened to a housing wall of the housing. The two pipe joints of the liquid cooling part are configured to be respectively connected to a liquid discharge pipe joint and a liquid inlet pipe joint of a liquid cooling heat dissipation part. According to this application, liquid for cooling can flow between the liquid cooling part and the liquid cooling heat dissipation part, to absorb a temperature of the liquid cooling part and cool the liquid cooling part, so as to increase a temperature difference between the liquid cooling part and the heat emitting element, and enable the liquid cooling part to quickly absorb heat generated by the heat emitting element. This improves effect of heat dissipation for the pluggable device.

## Description

This application claims priorities to Chinese Patent Application No. 202011266492.0, filed on November 13, 2020 and entitled "HEAT DISSIPATION METHOD AND HEAT DISSIPATION STRUCTURE AND DEVICE", and to Chinese Patent Application No. 202110221094.5, filed on February 26, 2021 and entitled "PLUGGABLE DEVICE, INFORMATION COMMUNICATION DEVICE, HEAT DISSIPATION SYSTEM, AND MANUFACTURING METHOD", which are incorporated herein by reference in their entirety.

### TECHNICAL FIELD

This application relates to the field of heat dissipation technologies, and in particular, to a pluggable device, an information communication device, a heat dissipation system, and a manufacturing method.

### BACKGROUND

A pluggable device, for example, an optical module for optical-to-electrical conversion, is used in cooperation with an optical communication device in optical fiber communication. For example, one end of the optical module is inserted into an optical cage (that is, an interface component) of a switch, and the other end of the optical module is for insertion by an optical fiber sub-assembly of an optical cable.

The optical module generates heat during operation. To dissipate the heat for the optical module, a heat sink is usually mounted on an outer surface of a housing of the optical cage of the switch. In this way, the heat generated by the optical module is transferred to the heat sink through the housing of the optical cage, and is dissipated outward by the heat sink.

However, there is a gap between the optical module inserted into the optical cage and the housing of the optical cage, and there is also a gap between the housing of the optical cage and the heat sink, resulting in poor effect of heat dissipation for the optical module.

### SUMMARY

This application provides a pluggable device, an information communication device, a heat dissipation system, and a manufacturing method, to overcome a problem in related technologies. The technical solution is as follows:

According to one aspect, a pluggable device is provided. The pluggable device includes a housing, a circuit board, a heat emitting element, and a liquid cooling part.

The circuit board, the heat emitting element, and the liquid cooling part are sequentially stacked in the housing, and two pipe joints of the liquid cooling part are both fastened to a housing wall of the housing.

The two pipe joints of the liquid cooling part are configured to be respectively connected to a liquid discharge pipe joint and a liquid inlet pipe joint of a liquid cooling heat dissipation part.

In an example, after the two pipe joints of the pluggable device are respectively connected to the liquid discharge pipe j oint and the liquid inlet pipe joint of the liquid cooling heat dissipation part, a water pump of the liquid cooling heat dissipation part operates, and may suction low-temperature liquid from a water tank of the liquid cooling heat dissipation part, and discharge the low-temperature liquid into a heat pipe of the liquid cooling part. The low-temperature liquid absorbs heat of the liquid cooling part so that a temperature of the liquid is increased. The liquid with the increased temperature flows to the water tank for cooling, and the cooled liquid is suctioned by the water pump again.

In this way, the liquid circulates between the liquid cooling part and the liquid cooling heat dissipation part, to cool the liquid cooling part, so as to increase a temperature difference between the liquid cooling part and the heat emitting element. The liquid cooling part is in contact with the heat emitting element, to accelerate heat transfer between the liquid cooling part and the heat emitting element. This improves effect of heat dissipation for the pluggable device.

In a possible implementation, the two pipe joints of the liquid cooling part are both located at a position that is of the housing and that is close to an exposed end of the pluggable device, and the exposed end of the pluggable device is an end portion that extends out of an information communication device when the pluggable device is inserted into the information communication device.

The position close to the exposed end of the pluggable device may be any position that is of the pluggable device and that extends out of a panel of the information communication device after the pluggable device is inserted into the information communication device.

In an example, the liquid cooling heat dissipation part is located outside the information communication device into which the pluggable device is inserted. For example, the liquid cooling heat dissipation part is located in a cabinet in which the information communication device is located, or the liquid cooling heat dissipation part is located in an equipment room in which the information communication device is located. In this case, the two pipe joints of the liquid cooling part may be located at the position that is of the pluggable device and that is close to the exposed end, so that after the pluggable device is inserted into the information communication device, the two pipe joints are exposed, and can be connected to the liquid discharge pipe joint and the liquid inlet pipe joint of the liquid cooling heat dissipation part that are located outside the information communication device.

In another example, the liquid cooling heat dissipation part is located in the information communication device into which the pluggable device is inserted, and the liquid discharge pipe joint and the liquid inlet pipe joint of the liquid cooling heat dissipation part are located on the panel of the information communication device. In this case, the two pipe joints of the liquid cooling part may be located at the position that is of the pluggable device and that is close to an exposed end opening, so that after the pluggable device is inserted into the information communication device, the two pipe joints are exposed, and can be connected to the liquid discharge pipe joint and the liquid inlet pipe joint that are located on the panel of the information communication device.

In a possible implementation, the two pipe joints of the liquid cooling part are both located at a position that is of the housing and that is close to an insertion end of the pluggable device, and the insertion end of the pluggable device is an end portion that extends into the information communication device when the pluggable device is inserted into the information communication device.

In an example, the liquid cooling heat dissipation part is located in the information communication device into which the pluggable device is inserted, and the liquid discharge pipe joint and the liquid inlet pipe joint of the liquid cooling heat dissipation part are located inside the information communication device. In this case, the two pipe joints of the liquid cooling part may be located at the position that is of the pluggable device and that is close to the insertion end, so that after the pluggable device is inserted into the information communication device, the two pipe joints are located inside the information communication device, and can be connected to the liquid discharge pipe joint and the liquid inlet pipe joint that are located inside the information communication device.

In a possible implementation, a thermal interface material is filled between the heat emitting element and the liquid cooling part.

The thermal interface material may be silicone grease, silica gel, a heat dissipation pad, a phase-change material, a phase-change metal sheet, a thermally conductive adhesive, or the like.

In an example, the liquid cooling part is located on a surface that is of the heat emitting element and that is away from the circuit board. To enable the liquid cooling part to quickly absorb heat of the heat emitting element, correspondingly, the liquid cooling part and the heat emitting element are closely attached. To further reduce thermal contact resistance between the liquid cooling part and the heat emitting element, correspondingly, the thermal interface material (Thermal Interface Material, TIM) may be filled between the liquid cooling part and the heat emitting element, to reduce the thermal contact resistance between the liquid cooling part and the heat emitting element, and accelerate the heat transfer between the liquid cooling part and the heat emitting element.

In a possible implementation, the heat emitting element is at least one of a main function component, a control chip, and a power management part of the pluggable device.

The heat emitting element may be a component that can generate large heat when the pluggable device operates.

For example, the heat emitting element may be at least one of a main function component, a control chip, and a power management part of the pluggable device.

In another aspect, an information communication device is provided, and the information communication device includes a subrack, interface components, and a liquid cooling heat dissipation part.

The interface components and the liquid cooling heat dissipation part are both located in the subrack, and socket openings of the interface components are located on a panel of the subrack.

A liquid discharge pipe joint and a liquid inlet pipe joint of the liquid cooling heat dissipation part are configured to be respectively connected to two pipe joints of a pluggable device inserted into the interface components, and the pluggable device is the foregoing pluggable device.

In an example, the information communication device includes the liquid cooling heat dissipation part, and the liquid discharge pipe joint and the liquid inlet pipe joint of the liquid cooling heat dissipation part can be respectively connected to the two pipe joints of the pluggable device inserted into the information communication device. In this way, liquid for cooling can flow between the liquid cooling part of the pluggable device and the liquid cooling heat dissipation part of the information communication device, to absorb a temperature of the liquid cooling part and cool the liquid cooling part, so as to increase a temperature difference between the liquid cooling part and the heat emitting element, and enable the liquid cooling part to quickly absorb heat generated by the heat emitting element. This improves effect of heat dissipation for the pluggable device.

In a possible implementation, the liquid discharge pipe joint and the liquid inlet pipe joint of the liquid cooling heat dissipation part are both located on the panel of the subrack.

In an example, the two pipe joints of the liquid cooling part may be located at a position that is of the pluggable device and that is close to an exposed end. In this case, the liquid discharge pipe joint and the liquid inlet pipe joint of the liquid cooling heat dissipation part may be located on the panel of the subrack, so that after the pluggable device is inserted into the information communication device, the liquid discharge pipe joint and the liquid inlet pipe joint that are located on the panel of the subrack can be respectively connected to the two pipe joints extending out of the panel of the subrack.

In a possible implementation, the liquid discharge pipe joint and the liquid inlet pipe joint of the liquid cooling heat dissipation part are both located inside the subrack, and correspond to positions of the interface components.

In an example, the two pipe joints of the liquid cooling part may be located at a position that is of the pluggable device and that is close to an insertion end. In this case, the liquid discharge pipe joint and the liquid inlet pipe joint of the liquid cooling heat dissipation part may be located inside the subrack, and correspond to the positions of the interface components, so that after the pluggable device is inserted into the information communication device, the liquid discharge pipe joint and the liquid inlet pipe joint that are located inside the subrack can be respectively connected to the two pipe joints located inside the subrack.

In a possible implementation, a plurality of interface components is provided, and at least one liquid cooling heat dissipation part is provided.

In an example, one information communication device is provided with a plurality of interface components, so that the information communication device can be connected to a plurality of pluggable devices. Correspondingly, a plurality of interface components may be provided, and at least one liquid cooling heat dissipation part may be provided.

The interface components and the liquid cooling heat dissipation part may be in a one-to-one correspondence, so that one liquid cooling heat dissipation part may perform heat dissipation for a pluggable device in one interface component.

Alternatively, one liquid cooling heat dissipation part may correspond to a plurality of interface components, so that one liquid cooling heat dissipation part may perform heat dissipation for pluggable devices in the plurality of interface components.

According to another aspect, a heat dissipation system is provided. The heat dissipation system includes an information communication device, a liquid cooling heat dissipation part, and the foregoing pluggable device.

The pluggable device is inserted into interface components of the information communication device, and the two pipe joints of the pluggable device are respectively connected to a liquid discharge pipe joint and a liquid inlet pipe joint of the liquid cooling heat dissipation part.

In an example, the heat dissipation system includes the liquid cooling heat dissipation part and a pluggable device having a liquid cooling part, and the pluggable device is inserted into the information communication device. When heat dissipation is needed, the liquid discharge pipe joint and the liquid inlet pipe joint of the liquid cooling heat dissipation part are respectively connected to two pipe joints of the liquid cooling part. In this way, liquid for cooling can flow between the liquid cooling part of the pluggable device and the liquid cooling heat dissipation part of the information communication device, to absorb a temperature of the liquid cooling part and cool the liquid cooling part, so as to increase a temperature difference between the liquid cooling part and a heat emitting element, and enable the liquid cooling part to quickly absorb heat generated by the heat emitting element. This improves effect of heat dissipation for the pluggable device.

In a possible implementation, the liquid cooling heat dissipation part is located in a subrack of the information communication device, and the liquid discharge pipe joint and the liquid inlet pipe joint of the liquid cooling heat dissipation part are both located on a panel of the subrack.

In an example, the two pipe joints of the liquid cooling part are located at a position that is of the pluggable device and that is close to an optical interface. In this case, the liquid cooling heat dissipation part may be located in the subrack of the information communication device, and the liquid discharge pipe joint and the liquid inlet pipe joint of the liquid cooling heat dissipation part are both located on the panel of the subrack, so that after the pluggable device is inserted into the information communication device, the liquid discharge pipe joint and the liquid inlet pipe joint that are located on the panel of the subrack can be respectively connected to the two pipe joints extending out of the panel of the subrack.

In a possible implementation, the liquid cooling heat dissipation part is located in an equipment room in which the information communication device is located.

In an example, the liquid cooling heat dissipation part may alternatively be located in the equipment room in which the information communication device is located, for example, be located in a cabinet of the equipment room, or may be located in an air channel between two cabinets.

According to another aspect, a method for manufacturing a pluggable device is provided, including:
mounting a circuit board in a housing;
welding a heat emitting element to a surface of the circuit board; and
mounting a liquid cooling part on a surface that is of the heat emitting element and that is away from the circuit board, and fastening two pipe joints of the liquid cooling part to a housing wall of the housing.

The two pipe joints are configured to be respectively connected to a liquid discharge pipe joint and a liquid inlet pipe joint of a liquid cooling heat dissipation part.

In an example, the pluggable device manufactured according to the foregoing method includes the liquid cooling part. The liquid cooling part is located in the housing of the pluggable device and is in contact with the heat emitting element in the housing. The two pipe joints of the liquid cooling part are located on the housing wall of the housing. The two pipe joints can be configured to connect to the liquid discharge pipe joint and the liquid inlet pipe joint of the liquid cooling heat dissipation part. In this way, liquid for cooling can flow between the liquid cooling part and the liquid cooling heat dissipation part, to absorb a temperature of the liquid cooling part and cool the liquid cooling part, so as to increase a temperature difference between the liquid cooling part and the heat emitting element, and enable the liquid cooling part to quickly absorb heat generated by the heat emitting element. This improves effect of heat dissipation for the pluggable device.

The information communication device in the foregoing solution may be a switch, a router, an access point (Access Point, AP) device, a blade server, or the like. A specific product of the information communication device is not limited in embodiments, and may be any device for insertion by the foregoing pluggable device.

### BRIEF DESCRIPTION OF DRAWINGS

FIG. 1 is a schematic diagram of applying a liquid cooling heat dissipation technology according to this application;
FIG. 2 is a schematic diagram of a structure of a pluggable device including a liquid cooling part according to this application;
FIG. 3 is a schematic diagram of a structure of a liquid cooling part of a pluggable device according to this application;
FIG. 4 is a schematic diagram of a structure of a pluggable device according to this application;
FIG. 5 is a schematic diagram of a structure of a liquid cooling heat dissipation part according to this application;
FIG. 6 is a schematic diagram of a structure of a liquid cooling heat dissipation part according to this application;
FIG. 7 is a schematic diagram of a structure of a connection between a liquid cooling heat dissipation part and a liquid cooling part of a pluggable device according to this application;
FIG. 8 is a schematic diagram of a structure of a connection between a liquid cooling heat dissipation part and a liquid cooling part of a pluggable device according to this application;
FIG. 9 is a schematic diagram of a structure of a connection between a liquid cooling heat dissipation part and a liquid cooling part of a pluggable device according to this application; and

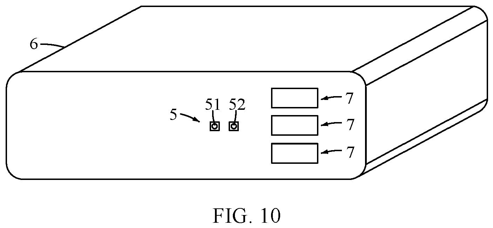

FIG. 10 is a schematic diagram of a structure of an information communication device including a liquid cooling heat dissipation part according to this application.

### Description of reference numerals:

1. housing; 2. circuit board; 3. heat emitting element;
4. liquid cooling part; 41. pipe joint; 42. substrate; 43. heat pipe;
5. liquid cooling heat dissipation part; 51. liquid discharge pipe joint; 52. liquid inlet pipe joint; 53. water pump; 54. water tank; 55. connection pipe; 56. liquid discharge pipe; 57. liquid inlet pipe; 58. heat sink;
6. subrack; 7. interface component; 8. optical interface; 9. electrical interface; 10. liquid transmission pipe; 100. pluggable device.

### DESCRIPTION OF EMBODIMENTS

Embodiments of this application provide a pluggable device. The pluggable device may be a device that is inserted into an information communication device and that generates large heat during operation. For example, the pluggable device may be an optical module. For another example, the pluggable device may be a pluggable hard disk. A specific product of the pluggable device is not limited in embodiments, and may be any device that generates large heat during operation.

The information communication device may be a device in the field of information and communication technologies, may be referred to as an ICT (Information Communications Technology) device for short, and is a device into which the pluggable device is inserted. For example, if the pluggable device is the optical module, an information communication device into which the optical module is inserted may be an optical communication device, such as a switch, an access point (Access Point, AP) device, or a router. For another example, if the pluggable device is the pluggable hard disk, an information communication device into which the pluggable hard disk is inserted may be a computer device, a blade server, or the like. A specific product of the information communication device is also not limited in embodiments, and may be any device for insertion by the foregoing pluggable device.

The pluggable device generates heat during operation. In this solution, a liquid cooling heat dissipation technology is used to dissipate the heat for the pluggable device. This improves effect of heat dissipation for the pluggable device.

For example, the pluggable device is the optical module. The optical module is a component for conversion between an optical signal and an electrical signal, and is used in cooperation with the optical communication device in optical fiber communication. For example, one end of the optical module is inserted into interface components (the interface component may also be referred to as an optical cage) of the optical communication device, and the other end of the optical module is for insertion by an optical fiber sub-assembly of an optical cable. However, the optical module generates heat during operation. The liquid cooling heat dissipation technology is used to dissipate the heat for the optical module. This improves effect of heat dissipation for the optical module.

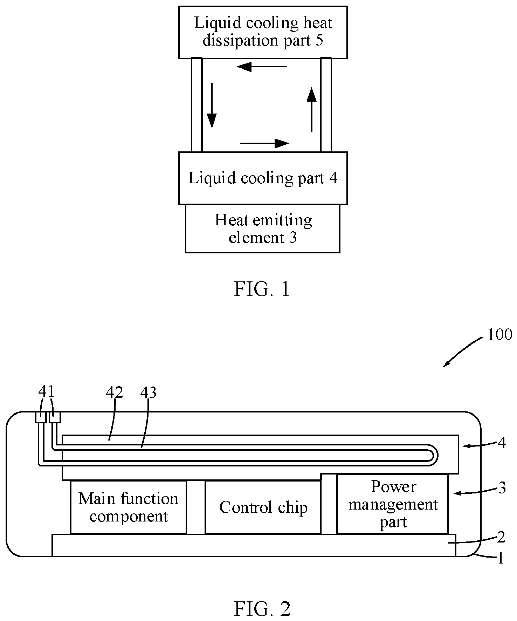

For ease of describing this solution, the liquid cooling heat dissipation technology is first described. As shown in FIG. 1, in the liquid cooling heat dissipation technology, a liquid cooling part 4 and a liquid cooling heat dissipation part 5 are included. The liquid cooling part 4 and the liquid cooling heat dissipation part 5 are connected to each other through pipes to form an enclosed circulation loop, and liquid flows in the circulation loop to achieve a cooling effect. Arrows in FIG. 1 are a possible flow direction of the liquid in the circulation loop. The liquid cooling part 4 is configured to absorb heat of a heat emitting element 3, and the liquid cooling heat dissipation part 5 is configured to enable the liquid to flow between the liquid cooling part 4 and the liquid cooling heat dissipation part 5, and may be further configured to reduce a temperature of the liquid, and the like.

In this solution, the liquid cooling heat dissipation technology is applied to the pluggable device for heat dissipation for the pluggable device. The pluggable device, such as the optical module, is in a small volume. The liquid cooling part 4 may be located in a housing of the pluggable device, and is in contact with the heat emitting element inside the pluggable device, to absorb the heat of the heat emitting element. The liquid cooling heat dissipation part 5 may be located outside the housing of the pluggable device, for example, may be located in the information communication device into which the pluggable device is inserted, or may be located in an equipment room in which the information communication device into which the pluggable device is inserted is located. The following describes this solution in detail.

As shown in FIG. 2, the pluggable device 100 includes a housing 1, a circuit board 2, a heat emitting element 3, and a liquid cooling part 4. The circuit board 2, the heat emitting element 3, and the liquid cooling part 4 are sequentially stacked in the housing 1. For example, the heat emitting element 3 is located on a surface of the circuit board 2, and the liquid cooling part 4 is located on a surface that is of the heat emitting element 3 and that is away from the circuit board 2. The liquid cooling part 4 is provided with two pipe joints 41. The two pipe joints 41 are both fastened to a housing wall of the housing 1, and are configured to be respectively connected to a liquid discharge pipe joint 51 and a liquid inlet pipe joint 52 of a liquid cooling heat dissipation part 5.

The heat emitting element 3 may be a component that can generate large heat when the pluggable device 100 operates.

For example, the heat emitting element 3 may be at least one of a main function component, a control chip, and a power management part of the pluggable device 100. The main function component is a component for the pluggable device to implement a main function. For example, if the pluggable device is an optical module, a function component may be an optical component, and is configured to implement conversion between an optical signal and an electrical signal.

For example, the heat emitting element 3 may be a main function component, may be a control chip, or may be a power management part. For another example, the heat emitting element 3 may be an assembly including a main function component and a control chip, may be an assembly including a main function component and a power management part, or may be an assembly including a control chip and a power management part. For another example, the heat emitting element 3 may be an assembly including a main function component, a control chip, and a power management part.

The heat emitting element 3 is not limited in this embodiment, and may be determined based on operating power of each component in the pluggable device. For example, a component whose operating power is higher than a set threshold is determined as the heat emitting element. For ease of description, an example shown in FIG. 2 in which the heat emitting element 3 is the assembly including a main function component, a control chip, and a power management part may be used.

The liquid cooling part 4 is a component that can absorb the heat generated by the heat emitting element 3.

In an example, the liquid cooling part 4 is located on the surface that is of the heat emitting element 3 and that is away from the circuit board 2. To enable the liquid cooling part 4 to quickly absorb the heat of the heat emitting element 3, correspondingly, the liquid cooling part 4 and the heat emitting element 3 are closely attached.

To further reduce thermal contact resistance between the liquid cooling part 4 and the heat emitting element 3, correspondingly, a thermal interface material (Thermal Interface Material, TIM) may be filled between the liquid cooling part 4 and the heat emitting element 3, to reduce the thermal contact resistance between the liquid cooling part 4 and the heat emitting element 3, and accelerate heat transfer between the liquid cooling part 4 and the heat emitting element 3.

The thermal interface material may be silicone grease, silica gel, a heat dissipation pad, a phase-change material, a phase-change metal sheet, a thermally conductive adhesive, or the like.

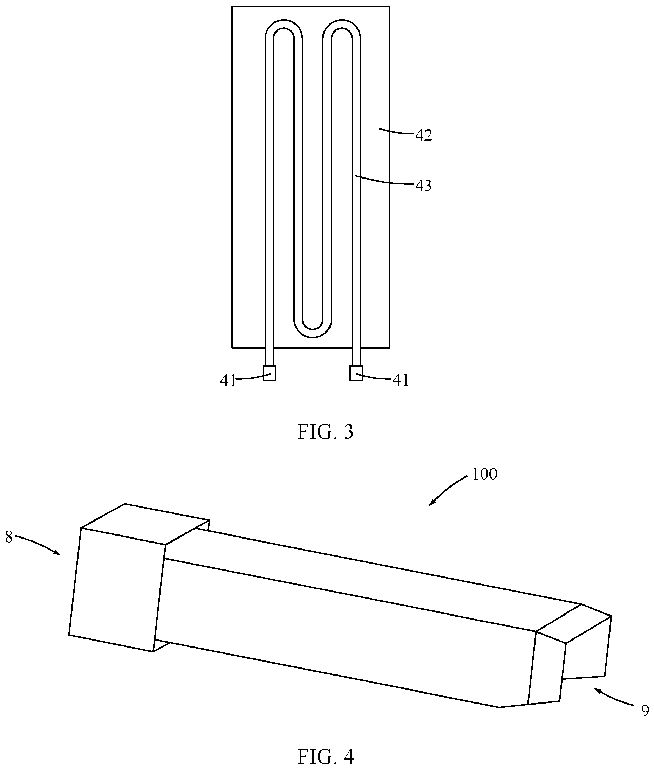

In an example, the liquid cooling part 4 may be a liquid cooling plate having a plate structure. For example, a structure of the liquid cooling part 4, refer to FIG. 3, may include a substrate 42, a heat pipe 43, and two pipe joints 41. The substrate 42 is in a plate structure that can absorb heat, and may be made of a material of an aluminum substrate, a copper substrate, or another metal plate with a high thermal conductivity. The heat pipe 43 is in a tubular structure that can absorb heat, and may be made of a material of a copper pipe, an aluminum pipe, or another metal pipe with a high thermal conductivity. The heat pipe 43 is located in the substrate 42, or the heat pipe 43 is laid on a surface of the substrate 42, or the like. A manner of fastening the heat pipe 43 to the substrate 42 is not limited in this embodiment. The pipe joints 41 are mounted on both two ends of the heat pipe 43, and the two pipe joints 41 are configured to be respectively connected to the liquid discharge pipe joint 51 and the liquid inlet pipe joint 52 of the liquid cooling heat dissipation part 5.

The liquid discharge pipe joint 51 is also a type of pipe joint through which a liquid discharged by the liquid cooling heat dissipation part 5 passes, and therefore is referred to as a liquid discharge pipe joint.

Similarly, the liquid inlet pipe joint 52 is also a type of pipe joint through which liquid flows into the liquid cooling heat dissipation part 5 passes, and therefore is referred to as a liquid inlet pipe joint.

In another example, the liquid cooling part 4 may alternatively be a liquid cooling pipe having a tubular structure, and pipe joints 41 are mounted on both two ends of the liquid cooling pipe. A specific structure of the liquid cooling part 4 is not limited in this embodiment, provided that the liquid cooling part 4 can be configured to absorb the heat of the heat emitting element 3. In the accompanying drawings, the liquid cooling part 4 in a plate structure may be used as an example.

To enable the pipe joints 41 of the liquid cooling part 4 to be connected to the liquid cooling heat dissipation part 5 located outside the pluggable device, correspondingly, the pipe joints 41 are fastened to the housing wall of the housing 1 of the pluggable device. For example, an outward-facing end portion of the pipe joint 41 is flush with the housing wall of the housing 1. For another example, the outward-facing end portion of the pipe joint 41 extends out of the housing 1.

For positions of the two pipe joints 41 of the liquid cooling part 4, the two pipe joints 41 of the liquid cooling part 4 may be both located at a position that is of the housing 1 and that is close to an exposed end of the pluggable device 100, and the exposed end of the pluggable device is an end portion that extends out of an information communication device when the pluggable device is inserted into the information communication device.

For example, the pluggable device is an optical module. As shown in FIG. 4, two ends of the optical module along a length direction are respectively provided with an optical interface 8 and an electrical interface 9. An end portion on which the optical interface 8 is located is marked as an exposed end of the optical module, and an end portion on which the electrical interface 9 is located is marked as an insertion end of the optical module. The optical interface 8 is for insertion by an optical fiber sub-assembly, and the electrical interface 9 is configured to be inserted into an optical cage of an optical communication device.

In this case, the two pipe joints 41 of the liquid cooling part 4 may be both located at a position that is of the housing 1 and that is close to the optical interface 8 of the optical module. The position close to the optical interface 8 of the optical module may be any position that is of the optical module and that extends out of a panel of the optical communication device after the optical module is inserted into the optical communication device.

For the positions of the two pipe joints 41 of the liquid cooling part 4, the two pipe joints 41 of the liquid cooling part 4 may be alternatively both located at a position that is of the housing 1 and that is close to an insertion end of the pluggable device 100, and the insertion end of the pluggable device is an end portion that extends into the information communication device when the pluggable device is inserted into the information communication device. For example, the pluggable device is the optical module, and the two pipe joints 41 of the liquid cooling part 4 are both located at a position that is of the housing 1 and that is close to the electrical interface 9 of the optical module.

For the positions of the two pipe joints 41 of the liquid cooling part 4, one pipe joint 41 of the liquid cooling part 4 may be located at the position that is of the housing 1 and that is close to the exposed end of the pluggable device, and the other pipe joint 41 of the liquid cooling part 4 may be located at the position that is of the housing 1 and that is close to the insertion end of the pluggable device.

Certainly, the two pipe joints 41 of the liquid cooling part may be alternatively located at a position between the exposed end and the insertion end of the pluggable device.

Specific positions of the two pipe joints 41 of the liquid cooling part 4 in the housing 1 are not limited in this embodiment, and may be flexibly selected based on a relationship between the liquid cooling heat dissipation part and the information communication device.

For example, the liquid cooling heat dissipation part 5 is located outside the information communication device into which the pluggable device is inserted. For example, the liquid cooling heat dissipation part 5 is located in a cabinet in which the information communication device is located, or the liquid cooling heat dissipation part 5 is located in an equipment room in which the information communication device is located. In this case, the two pipe joints 41 of the liquid cooling part 4 may be located at the position that is of the pluggable device and that is close to the exposed end, so that after the pluggable device is inserted into the information communication device, the two pipe joints 41 are exposed, and can be connected to the liquid discharge pipe joint 51 and the liquid inlet pipe joint 52 of the liquid cooling heat dissipation part 5 that are located outside the information communication device.

For another example, the liquid cooling heat dissipation part 5 is located in the information communication device into which the pluggable device is inserted, and the liquid discharge pipe joint 51 and the liquid inlet pipe joint 52 of the liquid cooling heat dissipation part 5 are located on a panel of the information communication device. In this case, the two pipe joints 41 of the liquid cooling part 4 may be located at the position that is of the pluggable device and that is close to the exposed end, so that after the pluggable device is inserted into the information communication device, the two pipe joints 41 are exposed, and can be connected to the liquid discharge pipe joint 51 and the liquid inlet pipe joint 52 that are located on the panel of the information communication device.

For another example, the liquid cooling heat dissipation part 5 is located in the information communication device into which the pluggable device is inserted, and the liquid discharge pipe j oint 51 and the liquid inlet pipe joint 52 of the liquid cooling heat dissipation part 5 are located inside the information communication device. In this case, the two pipe joints 41 of the liquid cooling part 4 may be located at the position that is of the pluggable device and that is close to the insertion end of the pluggable device, so that after the pluggable device is inserted into the information communication device, the two pipe joints 41 are located inside the information communication device, and can be connected to the liquid discharge pipe joint 51 and the liquid inlet pipe joint 52 that are located inside the information communication device.

For a solution that the two pipe joints 41 of the liquid cooling part 4 are located at the position that is of the pluggable device and that is close to the insertion end, the pluggable device may be integrated into the information communication device. In this way, the pluggable device does not need to be pulled out of the information communication device, so that the two pipe joints 41 of the pluggable device are always connected to the liquid discharge pipe joint 51 and the liquid inlet pipe joint 52 that are located inside the information communication device.

Alternatively, the pluggable device is still of a pluggable type, and positions of the liquid discharge pipe joint 51 and the liquid inlet pipe joint 52 that are located inside the information communication device correspond to positions of interface components of the information communication device. When the pluggable device is inserted into the interface components of the information communication device and abuts a bottom, the two pipe joints 41 of the pluggable device can be respectively connected to the liquid discharge pipe joint 51 and the liquid inlet pipe joint 52 that are located inside the information communication device.

The liquid cooling heat dissipation part 5 is a component configured to enable liquid to flow between the liquid cooling part 4 and the liquid cooling heat dissipation part 5.

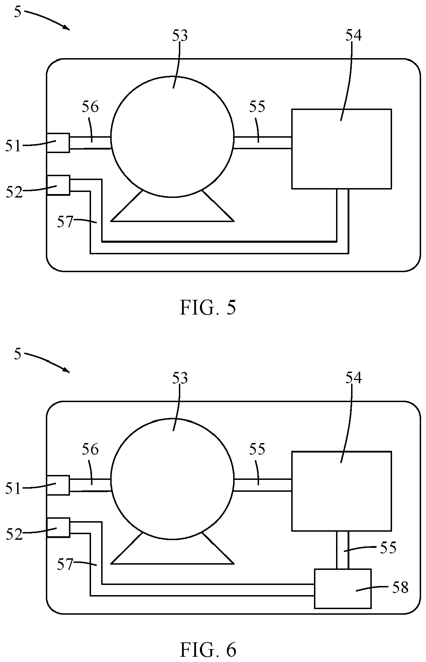

Refer to FIG. 5, the liquid cooling heat dissipation part 5 includes a liquid discharge pipe joint 51, a liquid inlet pipe joint 52, and a water pump 53. Because the liquid evaporates when circulating between the liquid cooling part 4 and the liquid cooling heat dissipation part 5, correspondingly, the liquid cooling heat dissipation part 5 not only includes the liquid discharge pipe joint 51, the liquid inlet pipe joint 52, and the water pump 53, but also includes a water tank 54. The water tank 54 is configured to store the liquid.

The liquid in the water tank 54 may be one of deionized water, an electronic fluoride liquid, and a refrigerant.

As shown in FIG. 5, the water pump 53 and the water tank 54 may be connected through a connection pipe 55. Because the water pump 53 suctions the liquid from the water tank 54, correspondingly, the connection pipe 55 is connected between a liquid inlet of the water pump 53 and a liquid outlet of the water tank 54. The liquid discharge pipe joint 51 may be directly mounted at a liquid outlet of the water pump 53. Alternatively, as shown in FIG. 5, the liquid discharge pipe joint 51 may be mounted at the liquid outlet of the water pump 53 through a liquid discharge pipe 56. For example, the liquid discharge pipe 56 is mounted at the liquid outlet of the water pump 53, and the liquid discharge pipe joint 51 is mounted at an end portion that is of the liquid discharge pipe 56 and that is away from the liquid outlet of the water pump 53.

The liquid inlet pipe joint 52 of the liquid cooling heat dissipation part 5 may be directly mounted at a liquid inlet of the water tank 54. Alternatively, as shown in FIG. 5, the liquid inlet pipe joint 52 may be mounted at the liquid inlet of the water tank 54 through a liquid inlet pipe 57. For example, the liquid inlet pipe 57 is mounted at the liquid inlet of the water tank 54, and the liquid inlet pipe joint 52 is mounted at an end portion that is of the liquid inlet pipe 57 and that is away from the liquid inlet of the water tank 54.

In another example, to quickly reduce a temperature of the liquid flowing into the liquid cooling heat dissipation part 5, correspondingly, as shown in FIG. 6, the liquid cooling heat dissipation part 5 may further include a heat sink 58, and the heat sink 58 is located between the liquid inlet of the water tank 54 and the liquid inlet pipe joint 52. For example, a liquid inlet of the heat sink 58 is directly connected to the liquid inlet pipe joint 52. Alternatively, the liquid inlet of the heat sink 58 is connected to the liquid inlet pipe joint 52 through the liquid inlet pipe 57. A liquid outlet of the heat sink 58 is directly connected to the liquid inlet of the water tank 54. Alternatively, the liquid outlet of the heat sink 58 is connected to the liquid inlet of the water tank 54 through a connection pipe 55.

A specific structure of the liquid cooling heat dissipation part 5 is not limited in this embodiment, and a structure shown in FIG. 5 may be used as an example.

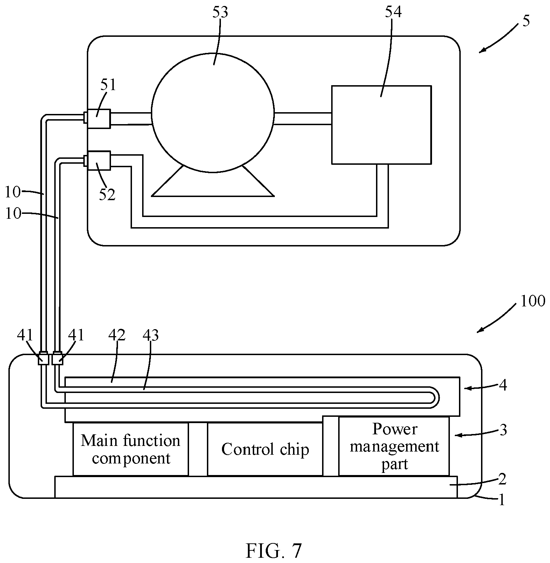

As described above, the two pipe joints 41 of the liquid cooling part 4 are respectively connected to the liquid discharge pipe joint 51 and the liquid inlet pipe joint 52 of the liquid cooling heat dissipation part 5. Correspondingly, the two pipe joints 41 may be respectively directly connected to the liquid discharge pipe joint 51 and the liquid inlet pipe joint 52 of the liquid cooling heat dissipation part 5. Alternatively, the two pipe joints 41 may be respectively connected to the liquid discharge pipe joint 51 and the liquid inlet pipe joint 52 of the liquid cooling heat dissipation part 5 through pipes. For example, as shown in FIG. 7, one pipe joint 41 is connected to the liquid discharge pipe joint 51 through a liquid transmission pipe 10, and the other pipe joint 41 is connected to the liquid inlet pipe joint 52 through a liquid transmission pipe 10.

A specific manner of a connection between the pipe joints of the liquid cooling part 4 and the pipe joints of the liquid cooling heat dissipation part 5 is not limited in this embodiment. An example in which the pipe joints of the liquid cooling part 4 are connected to the pipe joints of the liquid cooling heat dissipation part 5 through the liquid transmission pipes 10 shown in FIG. 7 may be used.

In this way, an enclosed circulation loop can be formed between the liquid cooling part 4 and the liquid cooling heat dissipation part 5, and liquid flows in the circulation loop to dissipate heat for the heat emitting element 3.

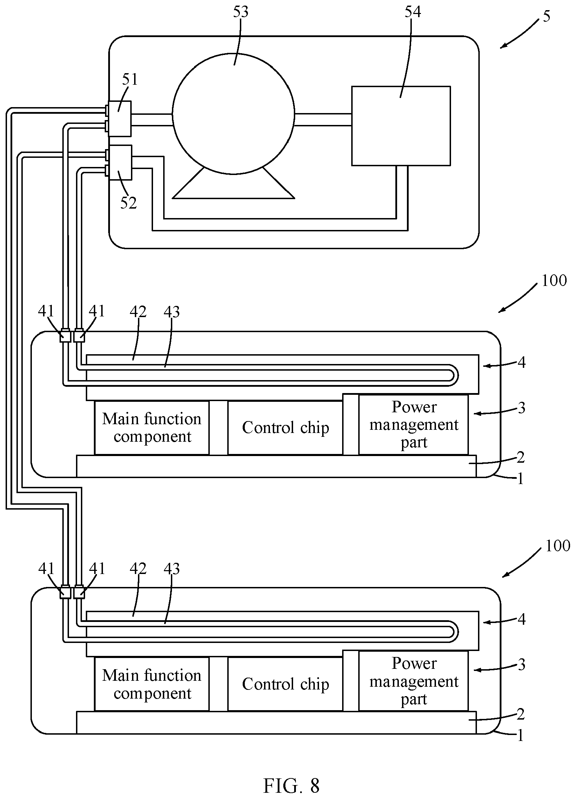

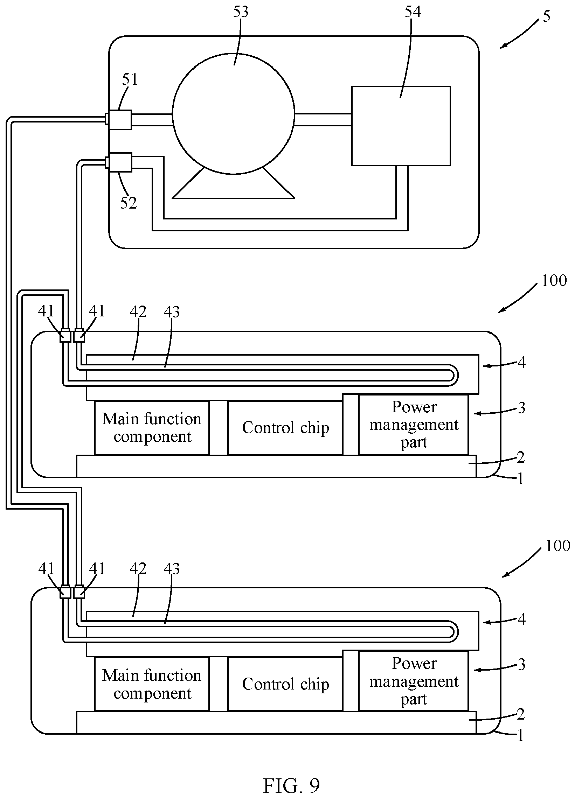

In an example, as shown in FIG. 7, one liquid cooling heat dissipation part 5 may perform heat dissipation for one pluggable device 100. In another example, one liquid cooling heat dissipation part 5 may alternatively perform heat dissipation for a plurality of pluggable devices 100. The plurality of pluggable devices 100 may be connected in parallel to the liquid cooling heat dissipation part 5, and the plurality of pluggable devices 100 is independent of each other in heat dissipation. Alternatively, the plurality of pluggable devices 100 may be connected in series to the liquid cooling heat dissipation part 5, and the plurality of pluggable devices 100 has a cascading relationship in heat dissipation. For example, as shown in FIG. 8, one liquid cooling heat dissipation part 5 dissipates heat for two pluggable devices 100. The two pluggable devices 100 are connected in parallel to the liquid cooling heat dissipation part 5, and the two pluggable devices 100 is independent of each other in heat dissipation. For another example, as shown in FIG. 9, one liquid cooling heat dissipation part 5 dissipates heat for two pluggable devices 100. The two pluggable devices 100 are connected in series to the liquid cooling heat dissipation part 5, and the two pluggable devices 100 has a cascading relationship in heat dissipation.

A quantity of pluggable device for which one liquid cooling heat dissipation part 5 performs heat dissipation is not limited in this embodiment, and may be flexibly set based on an actual requirement.

Based on the foregoing description, after the two pipe joints 41 of the pluggable device are respectively connected to the liquid discharge pipe joint 51 and the liquid inlet pipe joint 52 of the liquid cooling heat dissipation part 5, the water pump 53 of the liquid cooling heat dissipation part 5 operates, and may suction low-temperature liquid from the water tank 54, and discharge the low-temperature liquid into the heat pipe 43 of the liquid cooling part 4. The low-temperature liquid absorbs heat of the liquid cooling part 4 so that a temperature of the liquid is increased. The liquid with the increased temperature flows to the water tank 54 for cooling, and the cooled liquid is suctioned by the water pump 53 again. In this way, the liquid circulates between the liquid cooling part 4 and the liquid cooling heat dissipation part 5, to cool the liquid cooling part 4, so as to increase a temperature difference between the liquid cooling part 4 and the heat emitting element 3. The liquid cooling part 4 is in contact with the heat emitting element 3, to accelerate heat transfer between the liquid cooling part 4 and the heat emitting element 3. This improves effect of heat dissipation for the pluggable device.

In addition, the liquid for cooling circulates between the liquid cooling part 4 and the liquid cooling heat dissipation part 5, so that wastes of the liquid can be reduced, and resources can be saved.

In an example of this application, the pluggable device includes the liquid cooling part 4. The liquid cooling part 4 is located in the housing of the pluggable device and is in contact with the heat emitting element 3 in the housing. The two pipe joints 41 of the liquid cooling part 4 are located on the housing wall of the housing. The two pipe joints 41 can be configured to connect to the liquid discharge pipe joint 51 and the liquid inlet pipe joint 52 of the liquid cooling heat dissipation part 5. In this way, the liquid for cooling can flow between the liquid cooling part 4 and the liquid cooling heat dissipation part 5, to absorb a temperature of the liquid cooling part 4 and cool the liquid cooling part 4, so as to increase a temperature difference between the liquid cooling part 4 and the heat emitting element 3, and enable the liquid cooling part 4 to quickly absorb the heat generated by the heat emitting element 3. This improves effect of heat dissipation for the pluggable device.

An embodiment of this application further provides an information communication device. The information communication device is a device that is for insertion by a pluggable device and has the foregoing liquid cooling heat dissipation part 5. For example, if the pluggable device is an optical module, the information communication device is an optical communication device, for example, may be a switch device, an access point (Access Point, AP) device, or the like.

As shown in FIG. 9, the information communication device includes a subrack 6, interface components 7, and a liquid cooling heat dissipation part 5. The interface components 7 and the liquid cooling heat dissipation part 5 are both located in the subrack 6, and socket openings of the interface components 7 are located on a panel of the subrack 6. The liquid discharge pipe joint 51 and the liquid inlet pipe joint 52 of the liquid cooling heat dissipation part 5 are configured to be respectively connected to two pipe joints 41 that are of the pluggable device and that are inserted into the interface components 7. The pluggable device is the foregoing pluggable device.

The interface component 7 may also be referred to as an optical cage.

In an example, the socket openings of the interface components 7 are located on the panel of the subrack 6, so that the socket openings of the interface components 7 are exposed, and the pluggable device can be inserted into the interface components 7. After the pluggable device is inserted into the interface components 7, the two pipe joints 41 of the liquid cooling part 4 of the pluggable device can be respectively connected to the liquid discharge pipe joint 51 and the liquid inlet pipe joint 52 of the liquid cooling heat dissipation part 5.

In an example, the two pipe joints 41 of the liquid cooling part 4 may be located at a position that is of the pluggable device and that is close to an exposed end of the pluggable device. In this case, as shown in FIG. 9, the liquid discharge pipe joint 51 and the liquid inlet pipe joint 52 of the liquid cooling heat dissipation part 5 may be located on the panel of the subrack 6, so that after the pluggable device is inserted into the information communication device, the liquid discharge pipe joint 51 and the liquid inlet pipe joint 52 that are located on the panel of the subrack 6 can be respectively connected to the two pipe joints 41 extending out of the panel of the subrack 6.

In another example, the two pipe joints 41 of the liquid cooling part 4 may be located at a position that is of the pluggable device and that is close to an insertion end of the pluggable device. In this case, the liquid discharge pipe joint 51 and the liquid inlet pipe joint 52 of the liquid cooling heat dissipation part 5 may be located inside the subrack 6, and correspond to positions of the interface components 7, so that after the pluggable device is inserted into the information communication device, the liquid discharge pipe joint 51 and the liquid inlet pipe joint 52 that are located inside the subrack 6 can be respectively connected to the two pipe joints 41 located inside the subrack 6.

Whether the liquid discharge pipe joint 51 and the liquid inlet pipe joint 52 are specifically located on the panel of the subrack 6 or inside the subrack 6 is not limited in this embodiment, and may be flexibly determined based on positions of the two pipe joints 41 of the pluggable device.

Usually, one information communication device is provided with a plurality of interface components 7, so that the information communication device can be connected to a plurality of pluggable devices. Correspondingly, as shown in FIG. 9, a plurality of interface components 7 may be provided, and at least one liquid cooling heat dissipation part 5 may be provided. The interface components 7 and the liquid cooling heat dissipation part 5 may be in a one-to-one correspondence, or one liquid cooling heat dissipation part 5 corresponds to a plurality of interface components 7.

In an example of this application, the information communication device includes the liquid cooling heat dissipation part 5, and the liquid discharge pipe joint 51 and the liquid inlet pipe joint 52 of the liquid cooling heat dissipation part 5 can be respectively connected to the two pipe joints 41 of the pluggable device inserted into the information communication device. In this way, liquid for cooling can flow between the liquid cooling part 4 of the pluggable device and the liquid cooling heat dissipation part 5 of the information communication device, to absorb a temperature of the liquid cooling part 4 and cool the liquid cooling part 4, so as to increase a temperature difference between the liquid cooling part 4 and the heat emitting element 3, and enable the liquid cooling part 4 to quickly absorb heat generated by the heat emitting element 3. This improves effect of heat dissipation for the pluggable device.

An embodiment of this application further provides a heat dissipation system. The heat dissipation system includes an information communication device, a liquid cooling heat dissipation part 5, and the foregoing pluggable device. The pluggable device is inserted into interface components 7 of the information communication device, and the two pipe joints 41 of the pluggable device are respectively connected to a liquid discharge pipe joint 51 and a liquid inlet pipe joint 52 of the liquid cooling heat dissipation part 5.

The pluggable device may be an optical module, and in this case, the information communication device into which the pluggable device is inserted may be an optical communication device.

In an example, the liquid cooling heat dissipation part 5 may be located in a subrack 6 of the information communication device. For example, the two pipe joints 41 of the liquid cooling part 4 are located at a position that is of the pluggable device and that is close to an exposed end of the pluggable device. In this case, as shown in FIG. 9, the liquid cooling heat dissipation part 5 may be located in the subrack 6 of the information communication device, and the liquid discharge pipe joint 51 and the liquid inlet pipe joint 52 of the liquid cooling heat dissipation part 5 are both located on a panel of the subrack 6, so that after the pluggable device is inserted into the information communication device, the liquid discharge pipe joint 51 and the liquid inlet pipe joint 52 that are located on the panel of the subrack 6 can be respectively connected to the two pipe joints 41 extending out of the panel of the subrack 6.

In another example, the liquid cooling heat dissipation part 5 may be located in the subrack 6 of the information communication device. For example, the two pipe joints 41 of the liquid cooling part 4 are located at a position that is of the pluggable device and that is close to an insertion end of the pluggable device. In this case, the liquid cooling heat dissipation part 5 may be located in the subrack 6 of the information communication device, and the liquid discharge pipe joint 51 and the liquid inlet pipe joint 52 of the liquid cooling heat dissipation part 5 may be located inside the subrack 6, and correspond to positions of the interface components 7, so that after the pluggable device is inserted into the information communication device, the liquid discharge pipe joint 51 and the liquid inlet pipe joint 52 that are located inside the subrack 6 can be respectively connected to the two pipe joints 41 located inside the subrack 6.

In another example, the liquid cooling heat dissipation part 5 may alternatively be located in an equipment room in which the information communication device is located, for example, be located in a cabinet of the equipment room, or may be located in an air channel between two cabinets.

In an example of this application, the heat dissipation system includes the liquid cooling heat dissipation part 5 and the pluggable device having the liquid cooling part 4, and the pluggable device is inserted into the information communication device. When heat dissipation is needed, the liquid discharge pipe joint 51 and the liquid inlet pipe joint 52 of the liquid cooling heat dissipation part 5 are respectively connected to the two pipe joints 41 of the liquid cooling part 4. In this way, liquid for cooling can flow between the liquid cooling part 4 of the pluggable device and the liquid cooling heat dissipation part 5 of the information communication device, to absorb a temperature of the liquid cooling part 4 and cool the liquid cooling part 4, so as to increase a temperature difference between the liquid cooling part 4 and the heat emitting element 3, and enable the liquid cooling part 4 to quickly absorb heat generated by the heat emitting element 3. This improves effect of heat dissipation for the pluggable device.

An embodiment of this application further provides a method for manufacturing a pluggable device. The method may include the following steps:

First, a circuit board 2 is mounted in a housing 1.

A size of the circuit board 2 matches a size of the housing 1, so that the circuit board 2 can be fastened to the housing 1.

Then, a heat emitting element 3 is welded to a surface of the circuit board 2.

The heat emitting element 3 is a component with high operating power in the pluggable device, and can generate large heat during operation. For example, the heat emitting element 3 may be at least one of a main function component, a control chip, and a power management part of the pluggable device.

In an example, the heat emitting element 3 may be welded to the surface of the circuit board 2 by tin.

Then, a liquid cooling part 4 is mounted on a surface that is of the heat emitting element 3 and that is away from the circuit board 2, and two pipe joints 41 of the liquid cooling part 4 are both fastened to a housing wall of the housing 1.

The two pipe joints 41 are configured to be respectively connected to a liquid discharge pipe joint 51 and a liquid inlet pipe joint 52 of a liquid cooling heat dissipation part 5.

In an example, to absorb an assembly gap between the liquid cooling part 4 and the heat emitting element 3 to reduce thermal contact resistance, correspondingly, a thermal interface material may further be filled between the liquid cooling part 4 and the heat emitting element 3, so as to accelerate heat transfer between the liquid cooling part 4 and the heat emitting element 3.

In an example of this application, the manufactured pluggable device includes the liquid cooling part 4. The liquid cooling part 4 is located in the housing of the pluggable device and is in contact with the heat emitting element 3 in the housing. The two pipe joints 41 of the liquid cooling part 4 are located on the housing wall of the housing. The two pipe joints 41 can be configured to connect to the liquid discharge pipe joint 51 and the liquid inlet pipe joint 52 of the liquid cooling heat dissipation part 5. In this way, liquid for cooling can flow between the liquid cooling part 4 and the liquid cooling heat dissipation part 5, to absorb a temperature of the liquid cooling part 4 and cool the liquid cooling part 4, so as to increase a temperature difference between the liquid cooling part 4 and the heat emitting element 3, and enable the liquid cooling part 4 to quickly absorb heat generated by the heat emitting element 3. This improves effect of heat dissipation for the pluggable device such as an optical module.

The foregoing descriptions are merely one embodiment of this application, but are not intended to limit this application. Any modification, equivalent replacement, or improvement made without departing from the spirit and principle of this application should fall within the protection scope of this application.

## Claims

1. A pluggable device (100), wherein the pluggable device (100) comprises a housing (1), a circuit board (2), a heat emitting element (3), and a liquid cooling part (4);
the circuit board (2), the heat emitting element (3), and the liquid cooling part (4) are sequentially stacked in the housing (1), and two pipe joints (41) of the liquid cooling part (4) are both fastened to a housing wall of the housing (1); and
the two pipe joints (41) of the liquid cooling part (4) are configured to be respectively connected to a liquid discharge pipe joint (51) and a liquid inlet pipe joint (52) of a liquid cooling heat dissipation part (5).

2. The pluggable device (100) according to claim 1, wherein the two pipe joints (41) of the liquid cooling part (4) are both located at a position that is of the housing (1) and that is close to an exposed end of the pluggable device (100); and
the exposed end of the pluggable device (100) is an end portion that extends out of an information communication device when the pluggable device (100) is inserted into the information communication device.

3. The pluggable device (100) according to claim 1, wherein the two pipe joints (41) of the liquid cooling part (4) are both located at a position that is of the housing (1) and that is close to an insertion end of the pluggable device (100); and
the insertion end of the pluggable device (100) is an end portion that extends into an information communication device when the pluggable device (100) is inserted into the information communication device.

4. The pluggable device (100) according to any one of claims 1 to 3, wherein a thermal interface material is comprised between the heat emitting element (3) and the liquid cooling part (4).

5. The pluggable device (100) according to any one of claims 1 to 4, wherein the heat emitting element (3) is at least one of a main function component, a control chip, and a power management part of the pluggable device (100).

6. An information communication device, wherein the information communication device comprises a subrack (6), interface components (7), and a liquid cooling heat dissipation part (5);
the interface components (7) and the liquid cooling heat dissipation part (5) are both located in the subrack (6), and socket openings of the interface components (7) are located on a panel of the subrack (6); and
a liquid discharge pipe joint (51) and a liquid inlet pipe joint (52) of the liquid cooling heat dissipation part (5) are configured to be respectively connected to two pipe joints (41) of a pluggable device (100) inserted into the interface components (7), wherein the pluggable device (100) is the pluggable device (100) according to any one of claims 1 to 5.

7. The information communication device according to claim 6, wherein the liquid discharge pipe joint (51) and the liquid inlet pipe joint (52) of the liquid cooling heat dissipation part (5) are both located on the panel of the subrack (6) .

8. The information communication device according to claim 6 or 7, wherein a plurality of interface components (7) are provided, and at least one liquid cooling heat dissipation part (5) is provided.

9. A heat dissipation system, wherein the heat dissipation system comprises an information communication device, a liquid cooling heat dissipation part (5), and the pluggable device (100) according to any one of claims 1 to 5, wherein
the pluggable device (100) is inserted into interface components (7) of the information communication device, and the two pipe joints (41) of the pluggable device (100) are respectively connected to a liquid discharge pipe joint (51) and a liquid inlet pipe joint (52) of the liquid cooling heat dissipation part (5).

10. The heat dissipation system according to claim 9, wherein the liquid cooling heat dissipation part (5) is located in a subrack (6) of the information communication device, and the liquid discharge pipe joint (51) and the liquid inlet pipe joint (52) of the liquid cooling heat dissipation part (5) are both located on a panel of the subrack (6).

11. The heat dissipation system according to claim 9, wherein the liquid cooling heat dissipation part (5) is located in an equipment room in which the information communication device is located.

12. A method for manufacturing a pluggable device (100), comprising:
mounting a circuit board (2) in a housing (1);
welding a heat emitting element (3) to a surface of the circuit board (2); and
mounting a liquid cooling part (4) on a surface that is of the heat emitting element (3) and that is away from the circuit board (2), and fastening two pipe joints (41) of the liquid cooling part (4) to a housing wall of the housing (1), wherein
the two pipe joints (41) are configured to be respectively connected to a liquid discharge pipe joint (51) and a liquid inlet pipe joint (52) of a liquid cooling heat dissipation part (5).
